# FASCICULE DE BREVET EUROPEEN

(11) **EP 3 051 698 B1**
(45) Date de publication et mention de la délivrance du brevet: **13.06.2018**
(21) Numéro de dépôt: 16152278.4
(22) Date de dépôt: 21.01.2016
(51) Int. Cl.: H03K 17/96, B60R 13/02, B60K 37/06

(54) **TABLEAU DE COMMANDE POUR VEHICULE ET PROCEDE POUR FABRIQUER UN TEL TABLEAU DE COMMANDE**
BEDIENTAFEL FÜR FAHRZEUG, UND VERFAHREN ZUR HERSTELLUNG EINER SOLCHEN BEDIENTAFEL
CONTROL PANEL FOR A VEHICLE AND METHOD FOR MANUFACTURING SUCH A CONTROL PANEL

(30) Priorité: 27.01.2015 FR 1550631
(43) Date de publication de la demande: 03.08.2016
(73) Titulaire: Faurecia Intérieur Industrie, 92000 Nanterre (FR)
(72) Inventeur: BEN ABDELAZIZ, Omar, 60000 BEAUVAIS (FR)
(74) Mandataire: Cabinet Plasseraud

(56) Documents cités:
- EP-A1- 2 208 645
- WO-A1-97/11473
- WO-A1-2006/131462
- GB-A- 2 492 100

## Description

La présente invention est relative à un tableau de commande destiné à être agencé à l'intérieur d'un habitacle de véhicule, par exemple de véhicule automobile, ainsi qu'à un procédé pour fabriquer un tel tableau de commande.

Plus particulièrement, l'invention se rapporte à un tableau de commande destiné à être agencé à l'intérieur d'un habitacle de véhicule et comprenant :
- un élément d'habillage présentant une face extérieure destinée à être orientée en direction de l'habitacle et une face intérieure opposée à ladite face extérieure, la face extérieure comportant au moins une zone de commande,
- un élément de support présentant une face extérieure orientée vers la face intérieure de l'élément d'habillage et une face intérieure opposée à ladite face extérieure, et
- un film piézoélectrique.

Il est connu de l'état de la technique des tableaux de commande du type en question. Toutefois, les tableaux de commande de ce type existants nécessitent un effort de fabrication important avec l'ajout de pièces rapportées, notamment sur la face extérieure de l'élément d'habillage, et d'éléments de renfort, pour permettre une utilisation optimale du film piézoélectrique.

En outre, on connait, d'après le document WO97/11473 un accoudoir de véhicule automobile comprenant toutes les caractéristiques du préambule de la revendication 1, un outre une zone de commande qui comprend une résistance variable reliée à un module de contrôle électronique.

Ainsi, dans un souci de réduction des temps de fabrication tout en évitant un accroissement de la masse et du prix de l'assemblage et en assurant une utilisation optimale du film piézoélectrique, la présente invention vise à améliorer les dispositifs existants.

A cet effet, selon l'invention, un tableau de (30) commande.

Grâce à ces dispositions, on réalise un tableau de commande comprenant un élément piézoélectrique de façon simple sans remettre en cause ou dégrader les caractéristiques d'utilisation de l'élément piézoélectrique grâce à la présence de l'évidement situé en dessous de la zone de commande. Ainsi, l'élément piézoélectrique peut se déformer de façon à fonctionner de façon optimale au niveau de la zone de commande. En effet, dès qu'un utilisateur viendra appuyer sur la zone de commande, l'évidement en dessous de l'élément piézoélectrique permettra la déformation de l'élément piézoélectrique et la création d'un courant électrique qui pourra être transmis vers des connecteurs situés sous le tableau de commande.

Dans des modes de réalisation préférés de l'invention, on peut éventuellement avoir recours en outre à l'une et/ou à l'autre des dispositions suivantes :
- le film piézoélectrique est intégré entre l'élément d'habillage et l'élément de support par surmoulage de l'élément de support. On réalise un tableau de commande comprenant un élément piézoélectrique de façon simple grâce au surmoulage ;
- l'élément d'habillage comporte une pluralité de zones de commande, l'élément de support comporte une pluralité d'évidements et à chaque zone de commande correspond un évidement de l'élément de support et une portion de film piézoélectrique. Plusieurs zones de commande sont facilement crées sans nécessiter de pièces rapportées supplémentaires ;
- l'élément d'habillage comporte un matériau aluminium. Le film piézoélectrique n'interfère pas avec le matériau aluminium, contrairement à des tableaux de commande utilisant des technologies capacitives ;
- l'élément d'habillage comporte une couche comprenant un matériau en cuir ou succédané de cuir. Par exemple l'élément d'habillage comporte une couche supérieure, destinée à être visible par un passager du véhicule en cuir ou succédané de cuir ;
- l'élément d'habillage comporte une couche comprenant des fibres de carbone ;
- l'élément d'habillage comporte une couche comprenant un matériau thermoplastique ou un élastomère thermoplastique ;
- l'élément d'habillage présente une rainure entourant la zone de commande. Par exemple la rainure est présente sur la périphérie de la zone de commande ;
- le film piézoélectrique comporte une face extérieure orientée vers l'élément d'habillage et une face intérieure orientée vers l'élément de support ;
- le film piézoélectrique comporte un matériau adhésif thermo-réactif, le matériau adhésif thermo-réactif étant disposé sur la face intérieure et/ou la face extérieure du film piézoélectrique. Le matériau thermo-réactif est ainsi activé uniquement lors du surmoulage de l'élément de support ;
- le film piézoélectrique comporte au moins une piste conductrice imprimée agencée en regard du au moins un évidement ; l'impression de la piste conductrice est simple à mettre en oeuvre ;
- l'évidement s'étend sur une certaine longueur d'évidement, dans lequel la piste conductrice imprimée s'étend sur une certaine longueur de piste, et la longueur de piste est inférieure à la longueur d'évidement ; ainsi on forme une zone bouton légèrement plus petite que l'évidement de sorte à assurer une bonne déformation de l'élément piézoélectrique sur toute sa zone destinée à générer un signal électrique ;
- la zone de commande s'étend sur une certaine longueur de commande, dans lequel l'évidement s'étend sur une certaine longueur d'évidement, et dans lequel la longueur de commande est inférieure à la longueur d'évidement ;
- la zone de commande s'étend sur une certaine longueur de commande, dans lequel la piste conductrice imprimée s'étend sur une certaine longueur de piste, et la longueur de piste est égale à la longueur de commande ;

La présente invention concerne également une planche de bord pour véhicule équipée d'un tableau de commande tel que décrit.
La présente invention est également relative à un procédé pour fabriquer un tableau de commande destiné à être agencé à l'intérieur d'un habitacle de véhicule comprenant les étapes :
- mise à disposition d'une machine de moulage par injection avec un moule,
- fourniture d'un élément d'habillage présentant une face extérieure destinée à être orientée en direction de l'habitacle et une face intérieure opposée à ladite face extérieure, la face extérieure comportant au moins une zone de commande,
- positionnement de l'élément d'habillage dans le moule,
- fourniture d'un film piézoélectrique comportant une face intérieure et une face extérieure,
- positionnement et maintien en position du film piézoélectrique dans le moule, la face extérieure du le film piézoélectrique étant disposée sur la face intérieure de l'élément d'habillage,
- formation d'un élément de support par surmoulage dans le moule de matière sur une portion de la face intérieure du film piézoélectrique, l'élément de support formé présentant une face extérieure orientée vers la face intérieure de l'élément d'habillage et une face intérieure opposée à ladite face extérieure et un évidement au droit de la zone de commande, et
- intégration du film piézoélectrique entre l'élément d'habillage et l'élément de support lors de l'étape de surmoulage de l'élément de support.

Dans une variante de réalisation du procédé, la face extérieure du film piézoélectrique adhère à l'élément d'habillage, et dans lequel la face intérieure du film piézoélectrique adhère à l'élément de support lors de l'injection de matière dans le moule.

Selon une variante de réalisation, le maintien du film piézoélectrique en position dans le moule est réalisé par aspiration et/ou par un maintien mécanique.

D'autres caractéristiques et avantages de l'invention apparaîtront au cours de la description suivante d'une de ses formes de réalisation, donnée à titre d'exemple non limitatif, en regard des dessins joints.

Sur les dessins :
- la figure 1 est une vue schématique d'un habitacle de véhicule comprenant une planche de bord équipée d'un tableau de commande selon l'invention ;
- la figure 2 est une vue plane d'un exemple de face extérieure d'un élément d'habillage ;
- la figure 3 est une vue schématique en coupe selon la ligne III-III de la figure 1 du tableau de commande,
- la figure 4 est une vue schématique en coupe d'un film piézoélectrique selon un premier mode de réalisation,
- la figure 5 une vue schématique d'un film piézoélectrique selon un deuxième mode de réalisation,
- la figure 6 est une vue schématique en coupe d'un tableau de commande selon un mode de réalisation, dans lequel une rainure est présente..

Sur les différentes figures, les mêmes références désignent des éléments identiques ou similaires.

En l'espèce, dans la description qui suit, le terme « film piézoélectrique » doit être interprété au sens large pour qualifier un film qui comprend un ou plusieurs éléments piézoélectriques.

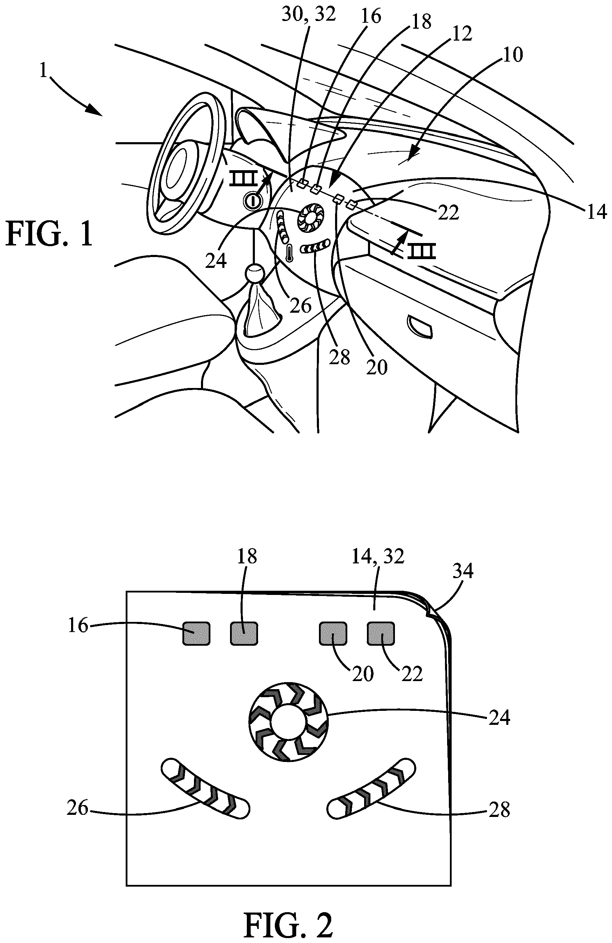

La figure 1 illustre un habitacle de véhicule 1 automobile avec une planche de bord 10. La planche de bord 10 comporte un tableau de commande 12. Le tableau de commande 12 comporte une face extérieure 14 orientée en direction de l'habitacle. Le tableau de commande 12 comporte une zone de commande 16, 18, 20, 22, 24, 26, 28. La zone de commande 16, 18, 20, 22, 24, 26, 28 est visible sur la face extérieure 14 du tableau de bord 10 et est accessible depuis l'habitacle 1. La zone de commande 16, 18, 20, 22, 24, 26, 28 peut par exemple être touchée du doigt par un usager du véhicule pour commander l'activation et ou désactiver des fonctionnalités du véhicule comme par exemple des feux de détresse, un verrouillage centralisé du véhicule, un système anti-patinage, un frein de stationnement, ou encore pour régler l'intensité d'un système de ventilation ou autres.

Tel que représenté sur la figure 1 le tableau de commande 12 comporte plusieurs zones de commande 16, 18, 20, 22, 24, 26, 28. Toutefois, il est possible que le tableau de commande 12 ne comporte qu'une seule zone de commande.

Dans le mode de réalisation illustré sur la figure 1, les différentes zones de commande 16, 18, 20, 22, 24, 26, 28 présentes sur la face extérieure du tableau de commande 12 sont indiquées par des marquages visibles pour un occupant du véhicule et/ou par des marquages pouvant être sentis au toucher par un occupant du véhicule, tels que des éléments en relief. En variante, on peut prévoir que seules les enveloppes à l'intérieur desquelles s'étendent les différentes zones de commande soient indiquées par de tels marquages.

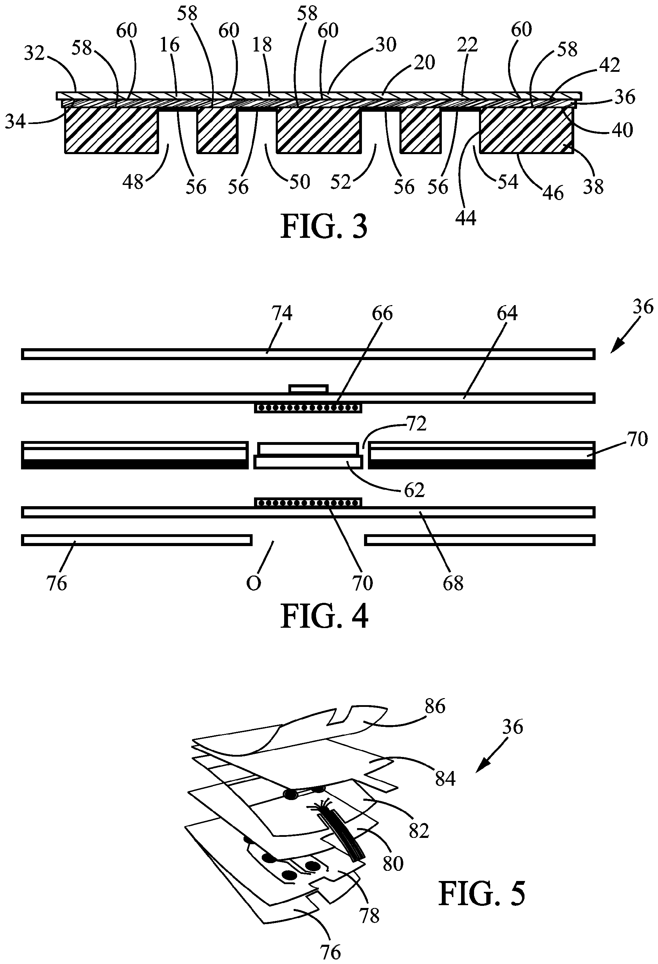

Comme visible sur la figure 3, le tableau de commande 12 comporte un élément d'habillage 30. L'élément d'habillage présente une face extérieure 32 destinée à être orientée en direction de l'habitacle et une face intérieure 34 opposée à ladite face extérieure 32. La face extérieure 32 de l'élément d'habillage est visible et accessible depuis l'habitacle 1 par un occupant du véhicule. La face extérieure 32 comporte au moins une zone de commande 16, 18, 20, 22, 24, 26, 28.

Le tableau de commande 12 comporte également un film piézoélectrique 36 (visible sur la figure 3). Le film piézoélectrique 36 est agencé entre un élément de support 38 du tableau de commande 12 et l'élément d'habillage 40 du tableau de commande 12. Plus précisément, le film piézoélectrique 36 comporte une face intérieure 40 et une face extérieure 42, opposée à la face intérieure 40.

Le film piézoélectrique 36 permet de produire de l'électricité lorsque celui-ci est déformé, plié ou pressé. le film piézoélectrique 36 est notamment intégré au droit de la zone de commande 16, 18, 20, 22, 24, 26, 28.

Le film piézoélectrique 36 peut être réalisé par différents procédés ou méthodes.

Par exemple, comme illustré sur la figure 4, le film piézoélectrique 36 comporte un disque piézoélectrique 62 ou encore une membrane piézoélectrique. Le disque piézoélectrique 62 est agencé entre un film supérieur 64 comprenant une électrode supérieure 66 et un film inférieur 68 comprenant une électrode inférieure 70. Les électrodes supérieure et intérieure 66, 70 sont au droit du disque piézoélectrique 62, de part et d'autre de celui-ci. Dans des variantes de réalisation, plusieurs disques piézoélectriques 62 peuvent être prévus. Pour garder un écartement constant entre les films inférieur et supérieur 68, 64 comprenant les électrodes inférieur et supérieur 70, 66 et/ou entre les disques piézoélectriques 62, dans le cas d'un film piézoélectrique comprenant plusieurs éléments piézoélectriques par exemple, un film-entretoise 70 peut être prévu. Le film-entretoise 70 peut comporter un orifice 72 à l'intérieur duquel est placé le disque piézoélectrique 62. Par exemple le film-entretoise 70 comporte plusieurs orifices 72 et à l'intérieur de chaque orifice 72 est positionné un disque piézoélectrique 62.

La mise en place du disque piézoélectrique 62 peut être réalisée par un bras motorisé par exemple. L'ensemble ainsi constitué peut ensuite être pris en sandwich entre deux couches de film 74, 76 comprenant un adhésif. La couche de film 76 en dessous du film inférieur 68 comprenant l'électrode inférieure 70 est en l'espèce prévue avec un orifice 0 pour permettre une déformation du disque piézoélectrique 62.

De part et d'autre du film piézoélectrique 36 ainsi constitué peuvent être disposés un élément de support et un élément d'habillage.

Un tel film piézoélectrique 36 permet notamment d'assurer une bonne sensibilité de la zone de détection. Un tel film piézoélectrique 36 permet également de réaliser un retour haptique. Le retour haptique permettrait notamment de confirmer à un utilisateur que la commande a bien été prise en compte. Le disque piézoélectrique ou la membrane piézoélectrique ont par exemple une forme circulaire plate. Dans le cas d'un film piézoélectrique permettant un retour haptique, le diamètre du disque piézoélectrique ou de la membrane piézoélectrique sera par exemple d'au moins 20 millimètres (mm). Le retour haptique peut être adapté selon la zone de commande à commander ou contrôler. Par exemple, si plusieurs zones de commande sont présentes, le retour haptique de la première zone de commande peut être différent (par exemple en intensité ou fréquence) du retour haptique de la deuxième zone de commande.

Dans un deuxième mode de réalisation, le film piézoélectrique peut être réalisé par impression, comme illustré notamment sur la figure 5. Un ou plusieurs élément(s) piézoélectrique(s) peuvent être imprimés sur un film. Pour l'impression d'un tel film piézoélectrique, un procédé d'impression rotatif, connu sous le nom de procédé *« Roll to Roll »* peut être utilisé. Ce type de procédé permet notamment un volume et une vitesse de production élevés tout comme une surface imprimable étendue, ainsi qu'une répétabilité du procédé et peu de perte de matière. Le film piézoélectrique 36 ainsi réalisé comporte par exemple, comme représenté sur la figure 5, une couche diélectrique 76, une première couche conductrice 78, une couche SIM 80, une seconde couche conductrice 82, un film polyester 84 et un film adhésif 86.

De part et d'autre du film piézoélectrique 36 ainsi constitué peuvent être disposés un élément de support et un élément d'habillage.

Un film piézoélectrique 36 réalisé par un procédé d'impression rotatif permet notamment d'assurer une bonne résistance à la température, de permettre la réalisation de forme en trois dimension (ou en volume), de permettre une impression sur une surface étendue. Il est ainsi possible de surmouler sans problèmes le film piézoélectrique 36 ainsi obtenu et les coûts de réalisation d'un tel film piézoélectrique 36 sont faibles.

Le tableau de commande 12 comporte également l'élément de support 38, comme précédemment mentionné. L'élément de support 38 présente une face extérieure 44 orientée vers la face intérieure 40 de l'élément d'habillage 30 et une face intérieure 46 opposée à ladite face extérieure 44. L'élément de support 38 est surmoulé directement sur le film piézoélectrique 36.

Comme visible sur la figure 3, le film piézoélectrique 36 s'étend sur une certaine surface entre l'élément d'habillage 30 et l'élément de support 38. Par exemple, le film piézoélectrique 36 s'étend sur toute la surface du tableau de commande 12.

La face intérieure 40 du film piézoélectrique 36 repose sur la face extérieure 44 de l'élément de support 38. La face extérieure 42 du film piézoélectrique 36 repose sur la face intérieure 34 de l'élément d'habillage 30.

Lors du surmoulage de l'élément de support 38, on crée directement au moins un évidement 48, 50, 52, 54 qui est formé au droit de la zone de commande 16, 18, 20, 22, 24, 26, 28. En l'espèce, le au moins un évidement 48, 50, 52, 54 est formé en regard du film piézoélectrique 36.

Le film piézoélectrique 36 est directement intégré entre l'élément d'habillage 30 et l'élément de support 38 lors surmoulage de l'élément de support 38. L'évidement 48, 50, 52, 54 crée sous le film piézoélectrique 36 permet au film piézoélectrique 36 de se déformer lorsqu'un utilisateur appui sur l'élément d'habillage 30 au droit de l'évidement 48, 50, 52, 54.

Dans un mode de réalisation, le film piézoélectrique 36 est intégré entre l'élément d'habillage 30 et l'élément de support 38 par collage. Dans ce mode de réalisation, l'évidement 48, 50, 52, 54 est réalisé préalablement à l'assemblage par collage, lors d'une étape de moulage de l'élément de support.

Ainsi, en plaçant l'évidement en regard de la zone de commande 16, 18, 20, 22, 24, 26, 28, l'utilisateur qui appuie sur la zone de commande 16, 18, 20, 22, 24, 26, 28 vient déformer le film piézoélectrique 36. Par exemple, l'évidement 48, 50, 52, 54 s'étend sur une certaine longueur d'évidement. La zone de commande 16, 18, 20, 22, 24, 26, 28 s'étend sur une certaine longueur de commande. La longueur de commande est inférieure à la longueur d'évidement.

Le film piézoélectrique 36 est imprimé en face de la zone de commande 16, 18, 20, 22, 24, 26, 28 avec des circuits conducteurs 56 (encore appelés piste conductrices), comme visible sur la figure 3. La déformation du film piézoélectrique 36 au droit des évidements 48, 50, 52, 54 (en face de la zone de commande16, 18, 20, 22, 24, 26, 28) engendre un signal électrique. Le signal électrique se transmet aux circuits conducteurs qui transportent le signal électrique vers un ou des connecteurs (non représentés) prévus sous le tableau de commande 12. Ces connecteurs vont ensuite commander l'activation et ou désactiver des fonctionnalités du véhicule telles que celles décrites précédemment.

Tel que représenté sur la figure 2, l'élément d'habillage 30 comporte sept zones de commande 16, 18, 20, 22, 24, 26, 28 distinctes. Toutefois, plus ou moins de sept zones de commande 16, 18, 20, 22, 24, 26, 28 peuvent être prévues. A chaque zone de commande 16, 18, 20, 22, 24, 26, 28 correspond un évidement 48, 50, 52, 54. Le film piézoélectrique 36 est par exemple continu. Le film piézoélectrique 36 s'étend en dessous de toutes les zones de commande 16, 18, 20, 22, 24, 26, 28 et se prolonge même au-delà de ces zones de commande 16, 18, 20, 22, 24, 26, 28.

Sur la figure 3, qui est une vue en coupe selon III-III de la figure 1, quatre zones de commande 16, 18, 20, 22, 24, 26, 28 sont visibles. Comme représenté sur la figure 3, à chaque zone de commande 16, 18, 20, 22, 24, 26, 28 de l'élément d'habillage 30 correspond un évidement 48, 50, 52, 54 de l'élément de support 38. Plus particulièrement, comme visible sur la figure 3, quatre évidements 48, 50, 52, 54 sont prévus au droit des zones de commande 16, 18, 20, 22, 24, 26, 28. Les quatre évidements 48, 50, 52, 54 sont formés directement lors du surmoulage de l'élément de support 38. Le film piézoélectrique 36 s'étend sur toute la surface entre l'élément de support 38 et l'élément d'habillage 30.

Le film piézoélectrique 36 est composé de zones bouton qui comportent les parties imprimées de pistes conductrices 56 (encore appelées circuits conducteurs 56). Comme précédemment mentionné, ces pistes conductrices 56 amènent un signal électrique vers des connecteurs prévus à l'arrière du tableau de bord pour transmettre le signal de commande de l'utilisateur vers l'interface à commander. Les pistes conductrices 56 sont imprimées sur la face intérieure 40 du film piézoélectrique 36. Par exemple, la piste conductrice 56 imprimée s'étend sur une certaine longueur de piste, et la longueur de piste est inférieure à la longueur d'évidement.

Les zones de l'élément de support 38 en contact direct avec le film piézoélectrique 36, notamment au voisinage du film piézoélectrique 36, permettent de rigidifier les zones du film piézoélectrique 36 qui ne sont pas destinées à être déformées. En d'autre termes, les zones de l'élément de renfort en contact direct avec le film piézoélectrique 36 sont situées en regard de portions de l'élément d'habillage 30 qui ne comportent pas de zones de commande 16, 18, 20, 22, 24, 26, 28. L'élément de renfort ou l'élément de support peuvent comprendre un matériau plastique.

Le film piézoélectrique est intégré à l'élément d'habillage 30 et à l'élément de support 38 lors du surmoulage de l'élément de support 38.

Ainsi, pour fabriquer le tableau de commande 12, on prévoit tout d'abord un moule. Dans ce moule on dispose dans un premier temps l'élément d'habillage 30. Par-dessus l'élément d'habillage 30, on vient déposer le film piézoélectrique 36. Lors de la dépose du film piézoélectrique 36, on s'assure que les zones comportant des pistes conductrices 56 imprimées sur le film piézoélectrique 36 soient en regard des zones destinées à formées les zones de commande sur l'élément d'habillage 30. Le film piézoélectrique 36 peut être maintenu en position dans le moule sur l'élément d'habillage 30 par exemple par aspiration. D'autres systèmes de maintien du film piézoélectrique 36 dans le moule peuvent être prévus, comme par exemple un système de maintien mécanique avec pinces ou clips. Des zones adhésives 58, 60 peuvent être prévues sur le film piézoélectrique 36 pour permettre à celui-ci d'adhérer à l'élément d'habillage 30 et/ou à l'élément de support 38. Par exemple, les zones adhésives 58, 60 peuvent être activées sous l'effet de la chaleur lors du surmoulage de l'élément de support 38. Les zones adhésives 58, 60, réalisées par exemple par des colles thermofusibles, peuvent être imprimées directement sur le film piézoélectrique 36. Par exemple, une zone adhésive 58 est prévue sur la face extérieure 42 du film piézoélectrique 36. Sous l'effet de la chaleur, la zone adhésive 58 est activée de sorte que le film piézoélectrique 36 colle à l'élément d'habillage 30.

L'élément d'habillage 30 comporte par exemple un matériau aluminium. Toutefois, d'autres matériaux peuvent être prévus. Par exemple, dans une réalisation alternative, l'élément d'habillage 30 comprend une couche en fibre de carbone, une couche en aluminium, une couche en bois, une couche en verre et/ou une couche minérale, par exemple de la pierre de schiste telle que le MICA ou l'ardoise. L'élément d'habillage 30 peut aussi comprendre une couche de cuir, une couche de succédané de cuir et/ou une couche en résine synthétique tel qu'un thermoplastique (ou élastomère thermoplastique). Ces couches forment une surface décorative de l'élément d'habillage.

Par exemple, l'élément d'habillage 30 comprend une couche d'un matériau (le matériau peut être un de ceux mentionnés ci-dessus tel que le cuir, un thermoplastique, du carbone, ...) qui peut être prévu avec un traitement de surface afin d'éviter une usure prématurée des zones de contrôle 16, 18, 20, 22, 24, 26, 28. Une fine couche de mousse peut être prévue sous la couche de matériau et plus précisément sous les zones de contrôle 16, 18, 20, 22, 24, 26, 28 pour donner un effet ressort à l'utilisateur lorsque celui-ci appuie sur la zone de contrôle 16, 18, 20, 22, 24, 26, 28. Le tableau de commande 12 peut ainsi être réalisé avec les étapes suivantes : préparation de la couche de matériau (faire les découpes nécessaires, les traitements, les marquages, les coutures, ...). Le film piézoélectrique 36 peut ensuite être fixé sur l'élément de support 38, par exemple de la colle peut être utilisée. Une carte électronique peut ensuite être assemblée sur l'élément de support 38.

L'élément d'habillage 30 peut également comprendre par exemple une couche de thermoplastique et peut être équipé avec un système de rétro éclairage pour identifier les zones de contrôle 16, 18, 20, 22, 24, 26, 28 et/ou comprendre une zone transparente ou translucide. Dans une variante de réalisation avec rétroéclairage, un dispositif d'éclairage est prévu et connecté à l'élément d'habillage.

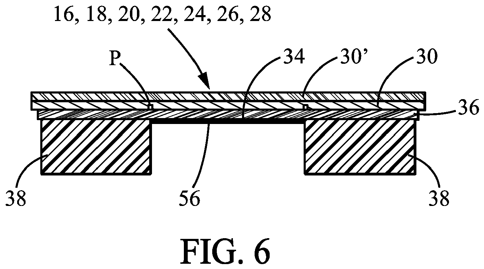

L'élément d'habillage 30, en particulier un élément d'habillage comprenant une couche de carbone ou d'aluminium ou de bois peut comprendre en outre une couche transparente 30' (telle qu'illustrée sur la figure 6). La couche transparente 30' peut être agencée au-dessus de la couche de carbone ou d'aluminium ou de bois. Par exemple la couche transparente 30' peut comprendre un matériau polyuréthane. La couche en carbone peut être surmoulée sur la couche transparente. Cette technique de moulage facilite la manutention de l'ensemble (couche décorative et couche transparente).

La face intérieure 34 de l'élément d'habillage 30, en particulier un élément d'habillage 30 comprenant une couche de carbone ou d'aluminium ou de bois peut comprendre une rainure P qui forme une zone périphérique entourant la zone de contrôle 16, 18, 20, 22, 24, 26, 28. Plus particulièrement, la zone périphérique de l'élément d'habillage 30 entourant la zone de contrôle 16, 18, 20, 22, 24, 26, 28 peut comprendre une épaisseur qui est plus petite que l'épaisseur du reste de l'élément d'habillage 30. Un tel affaiblissement permet une meilleure déformation de la zone directement au-dessus de la piste conductrice imprimée. En d'autres termes, la zone périphérique P forme une rainure dans l'élément d'habillage 30. La rainure peut être réalisée par laser ou par compression avant ou après le surmoulage.

La mise en oeuvre d'un film piézoélectrique 36 dans un tableau de bord comportant un élément d'habillage 30 en matériau aluminium est particulièrement avantageuse, l'aluminium n'interférant pas avec le film piézoélectrique 36.

## Revendications

1. Tableau de commande (12) destiné à être agencé à l'intérieur d'un habitacle (1) de véhicule et comprenant :
- un élément d'habillage (30) présentant une face extérieure (32) destinée à être orientée en direction de l'habitacle et une face intérieure (34) opposée à ladite face extérieure (32), la face extérieure 32) comportant au moins une zone de commande (16, 18, 20, 22, 24, 26, 28),
- un élément de support (38) présentant une face extérieure (44) orientée vers la face intérieure 34) de l'élément d'habillage (30) et une face intérieure (46) opposée à ladite face extérieure (44),
**caractérisé en ce qu'**il comprend un film piézoélectrique (36) qui s'étend entre l'élément d'habillage (30) et l'élément de support (38), et **en ce que** l'élément de support (38) comporte au moins un évidement (48, 50, 52, 54) au droit de la zone de commande (16, 18, 20, 22, 24, 26, 28).

2. Tableau de commande (12) selon la revendication 1, dans lequel le film piézoélectrique (36) est intégré entre l'élément d'habillage (30) et l'élément de support (38) par surmoulage de l'élément de support (38).

3. Tableau de commande (12) selon la revendication 1 ou 2, dans lequel l'élément d'habillage (30) comporte une pluralité de zones de commande (16, 18, 20, 22, 24, 26, 28), l'élément de support (38) comporte une pluralité d'évidements (48, 50, 52, 54) et à chaque zone de commande (16, 18, 20, 22, 24, 26, 28) correspond un évidement (48, 50, 52, 54) de l'élément de support (38) et une portion de film piézoélectrique (36).

4. Tableau de commande (12) selon l'une quelconque des revendications 1 à 3, dans lequel l'élément d'habillage (30) comporte un matériau aluminium.

5. Tableau de commande (12) selon l'une quelconque des revendications 1 à 3, dans lequel l'élément d'habillage (30) comporte une couche comprenant un matériau cuir ou de succédané de cuir.

6. Tableau de commande (12) selon l'une quelconque des revendications 1 à 3, dans lequel l'élément d'habillage (30) comporte une couche comprenant des fibres de carbone.

7. Tableau de commande (12) selon l'une quelconque des revendications 1 à 3, dans lequel l'élément d'habillage (30) comporte une couche comprenant un matériau thermoplastique.

8. Tableau de commande (12) selon l'une quelconque des revendications 1 à 7, dans lequel le film piézoélectrique (36) comporte une face extérieure (42) orientée vers l'élément d'habillage (30) et une face intérieure (40) orientée vers l'élément de support (38), et dans lequel le film piézoélectrique (36) comporte un matériau adhésif thermo-réactif, le matériau adhésif thermo-réactif étant disposé sur la face intérieure (40) et/ou la face extérieure (42) du film piézoélectrique (36).

9. Tableau de commande (12) selon l'une quelconque des revendications 1 à 8, dans lequel le film piézoélectrique (36) comporte au moins une piste conductrice (56) imprimée agencée en regard du au moins un évidement (48, 50, 52, 54).

10. Tableau de commande (12) selon la revendication 9, dans lequel l'évidement (48, 50, 52, 54) s'étend sur une certaine longueur d'évidement, dans lequel la piste conductrice (56) imprimée s'étend sur une certaine longueur de piste, et la longueur de piste est inférieure à la longueur d'évidement.

11. Tableau de commande (12) selon l'une quelconque des revendications 1 à 10, dans lequel l'élément d'habillage (30) comporte une rainure (P) entourant la zone de commande (16, 18, 20, 22, 24, 26, 28).

12. Planche de bord pour véhicule équipée d'un tableau de commande (12) selon l'une quelconque des revendications 1 à 11.

13. Procédé pour fabriquer un tableau de commande (12) destiné à être agencé à l'intérieur d'un habitacle (1) de véhicule comprenant les étapes :
- mise à disposition d'une machine de moulage par injection avec un moule,
- fourniture d'un élément d'habillage (30) présentant une face extérieure (32) destinée à être orientée en direction de l'habitacle et une face intérieure (34) opposée à ladite face extérieure, la face extérieure comportant au moins une zone de commande (16, 18, 20, 22, 24, 26, 28),
- positionnement de l'élément d'habillage (30) dans le moule,
- fourniture d'un film piézoélectrique (36) comportant une face intérieure (40) et une face extérieure (42),
- positionnement et maintien en position du film piézoélectrique (36) dans le moule, la face extérieure (42) du le film piézoélectrique (36) étant disposée sur la face intérieure 34) de l'élément d'habillage (30),
- formation d'un élément de support (38) par surmoulage dans le moule de matière sur une portion de la face intérieure (40) du film piézoélectrique (36), l'élément de support (38) formé présentant une face extérieure (44) orientée vers la face intérieure (34) de l'élément d'habillage (30) et une face intérieure (46) opposée à ladite face extérieure et un évidement (48, 50, 52, 54) au droit de la zone de commande (16, 18, 20, 22, 24, 26, 28), et
- intégration du film piézoélectrique (36) entre l'élément d'habillage (30) et l'élément de support (38) lors de l'étape de surmoulage de l'élément de support (38).

14. Procédé selon la revendication 13, dans lequel la face extérieure du film piézoélectrique (36) adhère à l'élément d'habillage (30), et dans lequel la face intérieure (40) du film piézoélectrique (36) adhère à l'élément de support (38) lors de l'injection de matière dans le moule.

## Patentansprüche

1. Bedientafel (12), welche dazu vorgesehen ist, in einem Innenraum einer Fahrerkabine (1) eines Fahrzeugs angeordnet zu sein, und welche umfasst:
- ein Verkleidungselement (30), welches eine äußere Fläche (32), welche dazu vorgesehen ist, in Richtung der Fahrerkabine orientiert zu sein, sowie eine innere Fläche (34) gegenüber der äußeren Fläche (32) aufweist, wobei die äußere Fläche (34) wenigstens eine Bedienzone (16, 18, 20, 22, 24, 26, 28) umfasst,
- ein Trageelement (38), welches eine äußere Fläche (44), welche in Richtung der inneren Fläche (32) des Verkleidungselements (30) orientiert ist, und eine innere Fläche (46) gegenüber der äußeren Fläche (44) aufweist,
- einen piezoelektrischen Film (36),
**dadurch gekennzeichnet, dass** der piezoelektrische Film (36) sich zwischen dem Verkleidungselement (30) und dem Trageelement (38) erstreckt, und dass das Trageelement (38) wenigstens eine Aussparung (48, 50, 52, 54) unter der Bedienzone (16, 18, 20, 22, 24, 26, 28) umfasst.

2. Bedientafel (12) nach Anspruch 1, wobei der piezoelektrische Film (36) zwischen dem Verkleidungselement (30) und dem Trageelement (38) durch Überformen des Trageelements (38) integriert ist.

3. Bedientafel (12) nach Anspruch 1 oder 2, wobei das Verkleidungselement (30) eine Mehrzahl von Bedienzonen (16, 18, 20, 22, 24, 26, 28) umfasst, das Trageelement (38) eine Mehrzahl von Aussparungen (48, 50, 52, 54) umfasst und jeder Bedienzone (16, 18, 20, 22, 24, 26, 28) eine Aussparung (48, 50, 52, 54) des Trageelements (38) und ein Abschnitt des piezoelektrischen Films (36) entspricht.

4. Bedientafel (12) nach einem der Ansprüche 1 bis 3, wobei das Verkleidungselement (30) ein Aluminiummaterial umfasst.

5. Bedientafel (12) nach einem der Ansprüche 1 bis 3, wobei das Verkleidungselement (30) eine Schicht umfasst, welche ein Ledermaterial oder ein Leder-Ersatzmaterial enthält.

6. Bedientafel (12) nach einem der Ansprüche 1 bis 3, wobei das Verkleidungselement (30) eine Schicht umfasst, welche Kohlenstofffasern enthält.

7. Bedientafel (12) nach einem der Ansprüche 1 bis 3, wobei das Verkleidungselement (30) eine Schicht umfasst, welche ein thermoplastisches Material enthält.

8. Bedientafel (12) nach einem der Ansprüche 1 bis 7, wobei der piezoelektrische Film (36) eine äußere Fläche, welche in Richtung des Verkleidungselements (30) orientiert ist, sowie eine innere Fläche umfasst, welche in Richtung des Trageelements (38) orientiert ist, und wobei der piezoelektrische Film (36) ein wärmereaktives Haftmaterial umfasst, wobei das wärmereaktive Haftmaterial an der inneren Fläche (40) und/oder der äußeren Fläche (42) des piezoelektrischen Films (36) aufgebracht ist.

9. Bedientafel (12) nach einem der Ansprüche 1 bis 8, wobei der piezoelektrische Film (36) wenigstens eine Leiterbahn (56) umfasst, welche gegenüber der wenigstens einen Ausnehmung (48, 50, 52, 54) aufgedruckt angebracht ist.

10. Bedientafel (12) nach Anspruch 9, wobei sich die Ausnehmung (48, 50, 52, 54) über eine bestimmte Ausnehmungslänge erstreckt, wobei sich die aufgedruckte Leiterbahn (56) über eine bestimmte Bahnlänge erstreckt, und wobei die Bahnlänge kleiner als die Ausnehmungslänge ist.

11. Bedientafel (12) nach einem der Ansprüche 1 bis 10, wobei das Verkleidungselement (30) eine Nut (P) umfasst, welche die Bedienzone (16, 18, 20, 22, 24, 26, 28) umschließt.

12. Armaturenbrett für ein Fahrzeug, ausgerüstet mit einer Bedientafel (12) nach einem der Ansprüche 1 bis 11.

13. Verfahren zum Herstellen einer Bedientafel (12), welche dazu vorgesehen ist, im Innenraum einer Fahrerkabine (1) eines Fahrzeugs angeordnet zu sein, umfassend die Schritte:
- Bereitstellen einer Injektionsgussvorrichtung mit einer Form,
- Beschaffen eines Verkleidungselements (30), welches eine äußere Fläche, welche dazu vorgesehen ist, in Richtung der Fahrerkabine orientiert zu sein, und eine innere Fläche gegenüber der äußeren Fläche aufweist, wobei die äußere Fläche wenigstens eine Bedienzone (16, 18, 20, 22, 24, 26, 28) umfasst,
- Platzieren des Verkleidungselements (30) in der Form,
- Beschaffen eines piezoelektrischen Films (36), welcher eine innere Fläche (40) und eine äußere Fläche (42) umfasst,
- Platzieren und in-Position-Halten des piezoelektrischen Films (36) in der Form, wobei die äußere Fläche (42) des piezoelektrischen Films (36) an der inneren Fläche (40) des Verkleidungselements (30) angeordnet ist,
- Bilden eines Trageelements (38) durch Überformen in der Form mit Material auf einem Abschnitt der inneren Fläche (40) des piezoelektrischen Films (36), wobei das gebildete Trageelement (38) eine äußere Fläche (44), welche in Richtung der inneren Fläche (34) des Verkleidungselements (30) orientiert ist, und eine innere Fläche (46) gegenüber der äußeren Fläche und eine Ausnehmung (48, 50, 52, 54) unter der Bedienzone (16, 18, 20, 22, 24, 26, 28) aufweist, und
- Integrieren des piezoelektrischen Films (36) zwischen dem Verkleidungselement (30) und dem Trageelement (38) während des Schritts des Überformens des Trageelements (38).

14. Verfahren nach Anspruch 13, wobei die äußere Fläche des piezoelektrischen Films (36) an dem Verkleidungselement (30) anhaftet, und wobei die innere Fläche (40) des piezoelektrischen Films (36) an dem Trageelement (38) während des Eingebens von Material in die Form anhaftet.

## Claims

1. Control panel (12) intended to be arranged inside a vehicle passenger compartment (1) and comprising:
- a trim element (30) having an external face (32) intended to be oriented towards the passenger compartment and an internal face (34) opposite said external face (32), the external face (34) including at least one control area (16, 18, 20, 22, 24, 26, 28),
- a supporting element (38) having an external face (44) oriented towards the internal face (32) of the trim element (30) and an internal face (46) opposite said external face (44),
- a piezoelectric film (36),
**characterised in that** the piezoelectric film (36) extends between the trim element (30) and the supporting element (38), **in that** the supporting element (38) includes at least one recess (48, 50, 52, 54) facing the control area (16, 18, 20, 22, 24, 26, 28).

2. Control panel (12) according to claim 1, wherein the piezoelectric film (36) is integrated between the trim element (30) and the supporting element (38) by overmoulding of the supporting element (38).

3. Control panel (12) according to claim 1 or 2, wherein the trim element (30) includes a plurality of control areas (16, 18, 20, 22, 24, 26, 28), the supporting element (38) includes a plurality of recesses (48, 50, 52, 54) and to each control area (16, 18, 20, 22, 24, 26, 28) corresponds a recess (48, 50, 52, 54) of the supporting element (38) and a portion of piezoelectric film (36).

4. Control panel (12) according to any one of claims 1 to 3, wherein the trim element (30) includes an aluminium material.

5. Control panel (12) according to any one of claims 1 to 3, wherein the trim element (30) includes a layer comprising a leather or imitation leather material.

6. Control panel (12) according to any one of claims 1 to 3, wherein the trim element (30) includes a layer comprising carbon fibres.

7. Control panel (12) according to any one of claims 1 to 3, wherein the trim element (30) includes a layer comprising a thermoplastic material.

8. Control panel (12) according to any one of claims 1 to 7, wherein the piezoelectric film (36) includes an external face oriented towards the trim element (30) and an internal face oriented towards the supporting element (38), and wherein the piezoelectric film (36) includes a heat-reactive adhesive material, the heat-reactive adhesive material being arranged on the internal face (40) and/or the external face (42) of the piezoelectric film (36).

9. Control panel (12) according to any one of claims 1 to 8, wherein the piezoelectric film (36) includes at least one printed conductive track (56) arranged facing the at least one recess (48, 50, 52, 54).

10. Control panel (12) according to claim 9, wherein the recess (48, 50, 52, 54) extends over a certain recess length, wherein the printed conductive track (56) extends over a certain track length, and the track length is less than the recess length.

11. Control panel (12) according to any one of claims 1 to 10, wherein the trim element (30) includes a groove (P) surrounding the control area (16, 18, 20, 22, 24, 26, 28).

12. Vehicle dashboard equipped with a control panel (12) according to any one of claims 1 to 11.

13. Method for manufacturing a control panel (12) intended to be arranged inside a vehicle passenger compartment (1) comprising the following steps:
- providing an injection moulding machine with a mould,
- supplying a trim element (30) having an external face intended to be oriented towards the passenger compartment and an internal face opposite said external face, the external face including at least one control area (16, 18, 20, 22, 24, 26, 28),
- positioning the trim element (30) in the mould,
- providing a piezoelectric film (36) including an internal face (40) and an external face (42),
- positioning and holding in position the piezoelectric film (36) in the mould, the external face (42) of the piezoelectric film (36) being arranged on the internal face (40) of the trim element (30),
- forming a supporting element (38) by overmoulding in the mould with material over a portion of the internal face (40) of the piezoelectric film (36), the supporting element (38) having an external face (44) oriented towards the internal face (34) of the trim element (30) and an internal face (46) opposite said external face and a recess (48, 50, 52, 54) next to the control area (16, 18, 20, 22, 24, 26, 28), and
- integrating the piezoelectric film (36) between the trim element (30) and the supporting element (38) during the step for overmoulding the supporting element (38).

14. Method according to claim 13, wherein the external face of the piezoelectric film (36) adheres to the trim element (30), and wherein the internal face (40) of the piezoelectric film (36) adheres to the supporting element (38) during the injection of material into the mould.
